# EUROPÄISCHE PATENTSCHRIFT

(11) **EP 0 794 606 B1**
(45) Veröffentlichungstag und Bekanntmachung des Hinweises auf die Patenterteilung: **22.08.2001**
(21) Anmeldenummer: 97103468.1
(22) Anmeldetag: 03.03.1997
(51) Int. Cl.: H02M 1/12

(54) **Elektrische Schaltungsanordnung für den Betrieb von Lampen**
Electrical circuit arrangement for operating lamps
Arrangement de circuits électriques pour le fonctionnement des lampes

(30) Priorität: 08.03.1996 DE 19608938; 10.01.1997 DE 19700666
(43) Veröffentlichungstag der Anmeldung: 10.09.1997
(73) Patentinhaber: Patent-Treuhand-Gesellschaft für elektrische Glühlampen mbH, 81543 München (DE)
(72) Erfinder: Schadhauser, Klaus, 81927 München (DE); Baggio, Stefano, 31100 Treviso (IT)

(56) Entgegenhaltungen:
- DE-A- 3 900 512
- DE-A- 4 418 886
- US-A- 4 764 684
- US-A- 4 933 804
- PATENT ABSTRACTS OF JAPAN vol. 011, no. 004 (E-468), 7.Januar 1987 & JP 61 180571 A (MATSUSHITA ELECTRIC IND CO LTD), 13.August 1986,
- PATENT ABSTRACTS OF JAPAN vol. 018, no. 617 (E-1634), 24.November 1994 & JP 06 233521 A (YOKOGAWA ELECTRIC CORP), 19.August 1994,

## Beschreibung

### Technisches Gebiet

Die Erfindung betrifft elektrische Schaltungsanordnungen für den Betrieb von elektrischen Lampen sowie ein Verfahren zur Herstellung derartiger Schaltungsanordnungen gemäß dem Oberbegriff der Ansprüche 1 bzw. 23.

Diese Art von elektrischen Schaltungsanordnungen eignet sich sowohl zum Betreiben von Entladungslampen, insbesondere von Leuchtstofflampen und Hochdrucklampen, als auch zum Betreiben von Glühlampen, z.B. Niedervolt-Halogenglühlampen. Für den Betrieb von Entladungslampen nennt man derartige Schaltungsanordnungen im allgemeinen "elektronische Vorschaltgeräte" (EVG), während für den Betrieb von Niedervolt-Halogenglühlampen die Bezeichnung "elektronischer Transformator" oder "elektronischer Konverter" gebräuchlich ist.

### Stand der Technik

Ohne entsprechende Gegenmaßnahmen erzeugen die genannten Schaltungsanordnungen im Betrieb u.a. unerwünschte Funkstörungen. Ursache hierfür sind meistens schnelle Potentialänderungen - im folgenden verkürzend auch als HF-Potential bezeichnet- auf der Leiterplatte, z.B. durch schnelle Schalttransistoren, gegenüber der geerdeten Gehäusemasse (Geräte der Schutzklasse I) oder der Umgebung bzw. Erde (Geräte der Schutzklasse II). Die mit den schnellen Potentialänderungen verbundenen elektrischen HF-Felder können über kapazitive Kopplungen Gleichtakt-Störströme influenzieren, die beispielsweise auf den Netzzuleitungen fließen. Die Stromschleife ist dabei über parasitäre Kapazitäten im wesentlichen zwischen der Schaltungsanordnung und Erde geschlossen. Eine ausführliche Beschreibung der Entstehung von Funkstörungen findet sich beispielsweise in W. Hirschmann und A. Hauenstein: "Schaltnetzteile", Siemens AG, Berlin, 1990, S. 72ff. Bezüglich der Grenzwerte für Funkstörungen speziell bei elektrischen Betriebsgeräten für Lampen ist die VDE 0875 - sie entspricht der internationalen Norm CISPR 15 - einzuhalten.

Eine gebräuchliche Maßnahme zur Unterdrückung von Gleichtakt-Störströmen besteht darin, ein Entstörfilter, z.B. eine stromkompensierte Drossel in die Netzzuleitungen der Schaltungsanordnung zu schalten. Die Auslegung stromkompensierter Drosseln ist beispielsweise in O. Kilgenstein: "Schaltnetzteile in der Praxis", Vogel Buchverlag, Würzburg, 1986, S. 355ff erläutert. Ihre Wirkung beruht darauf, daß der netzfrequente Nutzstrom ungedämpft passieren kann. Hochfrequente Gleichtakt-Störströme werden hingegen durch die hohe Induktivität der stromkompensierten Drossel ausgefiltert. Einem kompakten Aufbau sind allerdings Grenzen gesetzt, da durch unmittelbar benachbarte Bauteile und deren Störsignale die entstörende Wirkung einer stromkompensierten Drossel vermindert oder sogar - insbesondere aufgrund magnetischer Störfelder - in eine gegenteilige Wirkung umgekehrt werden kann.

Bei Geräten der Schutzklasse I können zusätzlich Y-Kondensatoren von den Netzzuleitungen gegen den Schutz- bzw. Erdleiter geschaltet sein, wodurch zumindest ein Teil der Gleichtakt-Störströme zur Erde abfließen kann. Bei Geräten der Schutzklasse II besteht diese Möglichkeit nicht.

Die EP-A-0 264 765 beschreibt einen elektronischen Konverter zum Betrieb von Niedervolt-Halogenglühlampen, der eine stromkompensierte Drossel zur Funkentstörung aufweist. Außerdem ist die Sekundärseite des Leistungsübertragers - dieser dient als Auskoppelkreis, der die getaktete Spannung des Schaltteils auf die Nennspannung der angeschlossenen Niedervolt-Halogenglühlampe transformiert - über einen Kondensator mit dem Plus- oder Minuspol des Netzgleichrichters verbunden. Dadurch wird ein HF-Kurzschluß erzeugt, der Störspannungen über dem Leistungsübertrager klein hält. Diese Maßnahme ist allerdings auf elektronische Konverter beschränkt.

In der DE-A-41 37 207 ist eine HF-Entstörung offenbart, die ebenfalls auf einem HF-Kurzschluß beruht und prinzipiell sowohl bei EVG's als auch bei elektronischen Konvertern eingesetzt werden kann. Dazu wird ein HF-Signal, im Falle eines EVG's beispielsweise aus dem Serienresonanzkreis der Entladungslampe ausgekoppelt und über einen Hochpaß mit einer in die Netzzuleitungen geschalteten Entstördrossel verbunden. Bei optimaler Dimensionierung des Hochpaßes fließen nahezu keine Störströme über die Netzzuleitungen. Allerdings ändert sich die HF-Impedanz der Entstördrossel in Abhängigkeit vom Wert des sie durchfließenden Eingangsstroms. Dadurch ändert sich die Enstörwirkung empfindlich mit der angeschlossenen Last.

In der Schrift US-A-4,764,684 ist eine Schaltungsanordnung mit einem Schutzfilter gegen hochfrequente Störsignale offenbart. Das Schutzfilter umfaßt eine Äquipotentialfläche, die mittels Filterkondensatoren mit den Eingangs- bzw. Ausgangsleitungen der Schaltungsanordnung verbunden ist. Die Äquipotentialfläche besteht in der Praxis aus mehreren miteinander elektrisch leitend verbundenen Elementen und umfaßt beispielsweise eine metallische Schicht auf der Leiterplatte der Schaltungsanordnung.

In der Schrift DE-A-39 00 512 ist ein Halbleiterbauelement für ein Schaltnetzteil zur Stromversorgung von starke Ströme aufnehmenden Verbrauchern, insbesondere elektrischen Schweißgeräten offenbart. Das Halbleiterbauelement ist auf einer metallischen Trägerplatte montiert. Zwischen Halbleiterbauelement und Trägerplatte ist eine Isolierschicht und eine Metallschicht angeordnet, wobei die Metallschicht an das Gleichpotential an dem Halbleiterbauelement angeschlossen ist.

In der Schrift US-A-4,933,804 ist eine Schaltungsanordnung mit Halbleiterschaltern offenbart. Zwischen den Eingangsleitungen (Phase, Neutral, Erde) sind Funkentstörkondensatoren geschaltet. Außerdem sind die Montagegehäuse der Halbleiterschalter mit der Phase oder dem Neutral-Leiter verbunden.

### Darstellung der Erfindung

Der Erfindung liegt die Aufgabe zugrunde, die genannten Nachteile zu beseitigen und eine Schaltungsanordnung zum Betreiben elektrischer Lampen anzugeben, die nur geringe Funkstörungen erzeugt und prinzipiell sowohl für elektronische Konverter als auch für elektronische Vorschaltgeräte geeignet ist. Ein weiterer Teil der Aufgabe ist es, eine besonders wirtschaftliche Lösung mit möglichst wenigen zusätzlichen Bauteilen anzugeben. Ein weiterer Teil der Aufgabe ist es, ein Verfahren zur Herstellung der Schaltungsanordnung auf einer Leiterplatte anzugeben.

Diese Aufgabe wird durch die kennzeichnenden Merkmale des Anspruchs 1 bzw. 23 gelöst. Besonders vorteilhafte Ausgestaltungen finden sich in den zugehörigen abhängigen Ansprüchen.

Zum besseren Verständnis der Erfindung wird zunächst der Begriff der elektrischen Äquipotentialfläche eingeführt. Unter diesem Begriff ist im folgenden eine elektrisch gut leitende Fläche, z.B. eine Folie, Schicht oder Platte aus Metall oder aus einem anderen elektrisch leitenden Material, beispielsweise aus elektrisch leitendem Kunststoff zu verstehen. Der Grundgedanke der Erfindung besteht nun darin, eine oder mehrere Äquipotentialflächen gegenüber der Umgebung elektrisch isoliert in der Nähe der Leiterbahnen und elektronischen Bauteile mit HF- Potential anzuordnen. Falls die Schaltungsanordnung in einem Schaltungsgehäuse aus elektrisch leitfähigem Material angeordnet ist, dient das Gehäuse selbst als Äquipotentialfläche. Andernfalls dient eine separate elektrisch leitfähige Abschirmfläche als Äquipotentialfläche. Darüber hinaus ist (sind) die Äquipotentialfläche(n) mit bezüglich der schnellen Potentialänderungen ruhendem Potential auf der Leiterplatte verbunden.

Prinzipiell ist nahezu jeder Punkt der Schaltungsanordnung zum Verbinden mit der Äquipotentialfläche geeignet, sofern er die vorgenannte Bedingung - vernachlässigbares HF-Potential - erfüllt. Allerdings ist darauf zu achten, daß der "kurzgeschlossene" HF-Störstrom nicht unerwünscht über Bauteile der Schaltungsanordnung abfließt und dadurch möglicherweise Störungen verursacht. Aus diesem Grunde ist eine entsprechende Masseleiterbahn zum Verbinden mit der Äquipotentialfläche besonders geeignet.

Hintergrund dieser Maßnahmen ist es - vereinfacht betrachtet - mit Hilfe der Äquipotentialfläche(n) gezielt (mindestens) eine zusätzliche Kapazität in die Schaltungsanordnung einzuführen. Die Zusatzkapazität fungiert quasi als möglichst niederohmiger "Kurzschluß" für die hochfrequente Funkstörquelle. Eine derartige Äquipotentialfläche kann nämlich- ähnlich wie die Umgebungserde, z.B. die geerdete Grundplatte einer Leuchte, in welche die Schaltungsanordnung eingebaut ist - als die zu den Leiterbahnen der Leiterplatte korrespondierende Gegenhälfte eines Zusatzkondensators interpretiert werden. Die Kapazität dieses Zusatzkondensators ist bevorzugt größer, insbesondere viel größer als die parasitäre Streukapazität der Leiterbahnen bezüglich der Erde. Im letzteren Fall wirkt die Zusatzkapazität quasi wie ein Kurzschluß für zeitlich schnell veränderliche, d.h. hochfrequente Störströme. Folglich werden die unerwünschten Störströme gegen Erde entsprechend reduziert und zwar im wesentlichen um so effizienter, je größer die Zusatzkapazität im Vergleich zur parasitären Streukapazität ist.

Zwar ist in der DE 44 18 886 A1 bereits eine Schaltungsanordnung mit einer Metallfläche zur Funkentstörung offenbart. Allerdings hat diese Metallfläche - im Gegensatz zu vorliegenden Erfindung - ein zeitlich schnell veränderliches Potential. Genauer gesagt ist dieses Potential bezüglich dem Störsignal zeitlich invertiert. Der Zweck dieser Maßnahme ist eine Kompensation der Störsignale durch die dazu gegenphasigen, von der Metallfläche erzeugten Signale. Ein Nachteil dieser Lösung ist, daß das Kompensationsprinzip eine möglichst genaue Abstimmung der konkrete geometrische Gestalt der Metallfläche erfordert, um eine unerwünschte Unter- bzw. Überkompensation zu vermeiden.

Im Gegensatz dazu ist bei der vorliegenden Erfindung die konkrete geometrische Gestalt der Äquipotentialfläche(n) relativ unkritisch in Bezug auf die prinzipielle Funktion. Eine aufwendige Abstimmung auf die jeweilige Schaltung wie im Stand der Technik ist überflüssig. Solange der Wert der Zusatzkapazität zumindest in der Größenordnung der parasitären Streukapazität der Schaltungsanordnung liegt, oder insbesondere größer als diese ist - was in der Praxis problemlos realisierbar ist - wird eine gute Reduzierung von Funkstörungen erreicht.

Der konkrete Wert der erfindungsgemäßen Zusatzkapazität ist durch die geometrische Gestalt der Äquipotentialfläche(n), insbesondere durch ihren Flächeninhalt sowie durch den Abstand zu den Leiterbahnen beeinflußbar. Innerhalb eines praktisch handhabbaren Bereichs nimmt der Wert zu mit zunehmendem Flächeninhalt und abnehmendem Abstand. Bei zwei oder mehr Äquipotentialflächen addieren sich die einzelnen Zusatzkapazitäten, entsprechend der Parallelschaltung von Kapazitäten.

In einer ersten erfindungsgemäßen Ausführung ist die Äquipotentialfläche auf der Oberseite der Leiterplatte angeordnet, also auf der Seite der Leiterplatte, auf der sich die Bauelemente befinden. In einer besonders bevorzugten Ausführung ist die gesamte Oberseite mit einer Kupferschicht bedeckt. Ausgenommen sind selbstverständlich die Durchführungen der Bauelemente zur Unterseite der Leiterplatte, also auf die Seite der Leiterplatte, auf der sich die Leiterbahnen -und ggf. direkt mit den Leiterbahnen verlötete SMD(Surface Mounted Device)-Bauteile - befinden. Diese großflächige Kupferschicht hat den Vorteil, daß sämtliche mit Störungen belastete Leiterbahnen von der Zusatzkapazität erfaßt werden. Außerdem wirkt sich dadurch die konkrete Anordnung der einzelnen Bauelemente auf der Leiterplatte - d.h. das Leiterplatten-Layout- weniger kritisch auf die Erzeugung von Störsignalen aus.

Bevorzugt ist diese Ausführung mit Hilfe einer gebohrten, doppelseitig kupferkaschierten Leiterplatte realisiert. Dabei sind wie üblich die Leiterbahnen aus der Kupferschicht der Unterseite der Leiterplatte mittels eines an sich bekannten Ätzprozesses gebildet. Die Kupferschicht der Oberseite ist an mindestens einer Stelle durch eine geeignete Bohrung in der Leiterplatte hindurch mit einer Masseleiterbahn kontaktiert, beispielsweise mittels einer Drahtbrücke. Der Vorteil dieser Lösung ist, daß außer der erwähnten elektrischen Verbindung zwischen Kupferschicht und Masseleiterbahn keine weiteren Maßnahmen oder zusätzliche Bauteile erforderlich sind. Die Masseleiterbahn ist gezielt so gewählt, daß sie sich während des Betriebs der Schaltungsanordnung bezüglich schneller Potentialänderungen (HF-Potential) auf ruhendem Potential befindet. Dabei hat ggf. eine relativ langsame bzw. statische Potentialdifferenz zwischen der Masseleiterbahn und der Erde keinen Einfluß auf die vorteilhafte Wirkung der Erfindung.

In einer zweiten Ausführung ist die Äquipotentialfläche auf der Unterseite der Leiterplatte angeordnet, auf der sich die Leiterbahnen befinden, also auf der Lötseite. Dazu ist eine flächige Kupferschicht auf der Leiterplatte zwischen den Leiterbahnen und von diesen elektrisch isoliert aufgebracht. Die flächige Kupferschicht kann auch aus mehreren miteinander elektrisch leitend verbundenen Teilflächen bestehen. Die Verbindung mit einer Masseleiterbahn erfolgt beispielsweise über eine Lötbrücke. Diese Ausführung ist in erster Linie für einseitig kupferkaschierte Leiterplatten vorgesehen, d.h. wenn die Oberseite der Leiterplatte keine Kupferschicht aufweist.

In einer weiteren Ausführung ist die Äquipotentialfläche durch eine im Bereich der Ober- und/oder Unterseite der Leiterplatte angeordnete elektrisch leitende Abschirmfläche bzw. -flächen, z.B. Kupfer- oder Aluminiumblech oder -folie gebildet. Bevorzugt ist die bzw. sind die Abschirmflächen mindestens so groß wie die Leiterplatte und im wesentlichen parallel zur Leiterplatte angeordnet, z.B. auf der Innenseite des Gehäusedeckels bzw. - bodens der Schaltungsanordnung. Außerdem ist die Abschirmfläche mit einer Masseleiterbahn kontaktiert, z.B. mittels eines Kupferbandes.

Eine weiteres Ausführungsbeispiel schlägt eine vorteilhafte Verbindung vor zwischen der Äquipotentialfläche, d.h. gegebenenfalls dem Schaltungsgehäuse selbst (Fall I) oder der elektrisch leitenden Abschirmfläche (Fall II), z.B. Aluminiumfolie, einerseits und der Masseleiterbahn oder allgemein einem bezüglich HF-Potential ruhendem Potential auf der Leiterplatte anderseits.

Erfindungsgemäß ist eine Drahtbrücke auf der Leiterplatte angeordnet derart, daß sie über einen Rand der Leiterplatte gebogen und dort als elektrischer Kontakt für die Äquipotentialfläche fungiert. Dazu ist ein erstes Ende der Drahtbrücke mit der Masseleiterbahn bzw. einem ruhenden Potential auf der Leiterplatte verbunden. Das zweite Ende der Drahtbrücke ist über den Rand der Leiterplatte gebogen. Nach dem Einsetzen der Leiterplatte in das Schaltungsgehäuse drückt im ersten Fall die Gehäusewandung selbst gegen den am Leiterplattenrand überstehenden Teil der Drahtbrücke. Im zweiten Fall drückt die Gehäusewandung zunächst gegen die Abschirmfläche - die sich ebenfalls über den besagten Rand erstreckt - und folglich selbige gegen den am Leiterplattenrand überstehenden Teil der Drahtbrücke. In beiden Fällen ist durch die geschilderte Anordnung mittels der Drahtbrücke eine elektrische Verbindung zwischen der Masseleiterbahn und der Äquipotentialfläche - d.h. Schaltungsgehäuse im Fall I bzw. Abschirmfläche im Fall II - hergestellt.

Der Vorteil dieser Lösung ist, daß außer der Kontaktierung durch Kraftschluß keine zusätzliche aufwendige Verbindungstechnik, z.B. Löten oder Nieten, erforderlich ist. Außerdem ist die Herstellung der Schaltungsanordnung inklusive Leiterplatte und Abschirmung sowie deren Montage im Gehäuse gut automatisierbar, einfach und preiswert.

In einer besonders bevorzugten Variante ist das zweite Ende der Drahtbrükke ebenfalls mit der Leiterplatte verbunden, z.B. durch eine Löt- oder Klebestelle. Dadurch ist sichergestellt, daß sich die Drahtbrücke während der Montage nicht verschiebt und dadurch im ungünstigsten Fall keinen Kontakt mit der Äquipotentialfläche bildet. Dies läßt sich besonders vorteilhaft mit Hilfe einer kleinen Aussparung am Leiterplattenrand, z.B. durch eine Kerbe oder eine halbkreisförmige Bohrung realisieren, in welcher der um den Leiterplattenrand gebogene Teil der Drahtbrücke teilweise eingebettet ist. Die Abmessungen der Aussparung und der Drahtdurchmesser sind dabei so aufeinander abgestimmt, daß ein ausreichender Teil der Drahtbrücke über die Aussparung hinausragt und als Kontaktfläche dienen kann.

Erfindungsgemäß erfolgt die Herstellung der Leiterplatte mit der Schaltungsanordnung folgendermaßen. Wie allgemein in der Massenfertigung üblich, werden mehrere Schaltungsanordnungen auf einer großen Nutzplatte automatisiert gefertigt. Anschließend werden die einzelnen Leiterplatten mit den darauf befindlichen Schaltungsanordnungen aus der großen Nutzplatte herausgetrennt. Dazu werden die zwischen den einzelnen, auf der Nutzplatte nebeneinander angeordneten Schaltungsanordnungen mittels Ritzfräsungen begrenzt. Die Ritzfräsungen dienen am Ende der Herstellung als Sollbruchstellen. Innerhalb der Ritzfräsungen, die nebeneinander angeordnete Schaltungsanordnungen voneinander trennen, wird jeweils eine Bohrung pro Drahtbrücke angebracht. Das erste Ende der Drahtbrücke wird mit der Masseleiterbahn der jeweiligen Schaltungsanordnung verbunden. Das zweite Ende der Drahtbrücke wird durch die Bohrung hindurch geführt und mit einem "halben" Lötpunkt, welcher die betreffende Ritzfräsung ausspart, an der Leiterplatte befestigt.

Desweiteren sind auch beliebige Kombinationen der vorgenannten Ausführungen denkbar, insbesondere wenn erhöhte Anforderungen an die Störfreiheit gestellt werden. Im Einzelfall ist dann die mögliche zusätzliche Verringerung von Störsignalen gegen den ebenfalls zusätzlichen Aufwand und die damit verbundenen Kosten abzuwiegen.

### Beschreibung der Zeichnungen

Die Erfindung wird im folgenden anhand einiger Ausführungsbeispiele näher erläutert. Es zeigen
- Fig. 1a: eine schematische Darstellung der kapazitiven Kopplung zwischen einer Leiterbahn mit HF-Potential und Erde, ohne Maßnahmen zur Reduzierung von Funkstörungen,
- Fig. 1b: wie Figur 1a, aber mit einer mit Massepotential verbundenen Kupferplatte zur Reduzierung von Funkstörungen,
- Figur 1c: eine gegenüber Figur 1b geänderte Anordnung einer mit Masse verbundenen Kupferplatte,
- Figur 2: eine Anordnung einer mit Massepotential verbundenen Kupferschicht auf einer Leiterplatte.
- Figur 3a: die Schnittdarstellung eines Schaltungsgehäuses inklusive Leiterplatte und Abschirmfläche, die mittels Drahtbrücke mit einer Masseleiterbahn kontaktiert ist,
- Figur 3b: wie Figur 3a, aber in der Draufsicht,
- Figur 4: eine Nutzplatte, aus der eine Vielzahl von Leiterplatten mit Drahtbrücke hergestellt werden.

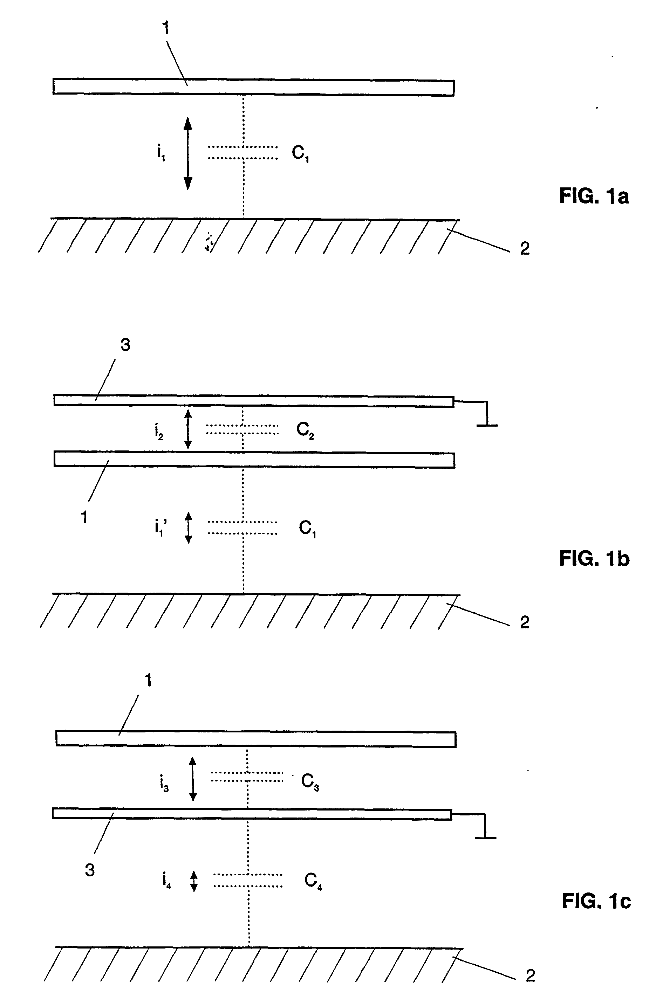

Die Figuren 1a - 1c dienen im folgenden zur vereinfachenden Erläuterung des Grundprinzips der Erfindung. Gleiche Merkmale sind dabei durch gleiche Ziffern bezeichnet. Eine Festlegung auf irgendeine theoretische Erklärung ist nicht beabsichtigt.

In Figur 1a ist zunächst schematisch die kapazitive Kopplung zwischen einer Leiterbahn 1 mit schnellen Potentialänderungen, d.h. mit HF-Potential und Erde 2 dargestellt. Ohne Maßnahmen zur Reduzierung von Funkstörungen fließt über die parasitäre Kapazität C₁ - symbolisiert durch einen gepunkteten Kondensator zwischen der Leiterbahn 1 und der Erde 2 - ein unerwünschter Funkstörstrom i₁.

Die erfindungsgemäße Anordnung in Figur 1b weist zusätzlich eine mit Massepotential verbundene Kupferplatte 3 auf, die als Äquipotentialfläche mit bezüglich des HF-Potentials der Leiterbahn 1 ruhendem Potential fungiert. Die Kupferplatte 3 ist auf der von der Erde 2 abgewandten Seite der Leiterbahn 1 und im wesentlichen parallel dazu angeordnet. Aufgrund geeigneter Dimensionierung und Anordnung der Kupferplatte 3 resultiert eine parasitäre Kapazität C₂ zwischen der Kupferplatte 3 und der Leiterbahn 1, die größer als die parasitäre Kapazität C₁ zwischen der Leiterbahn 1 und Erde 2 ist, d.h. C₂ > C₁,. Idealerweise ist C₂ >> C₁. Unter der Voraussetzung, daß C₂·U₂ > C₁·U₁ - dabei bezeichnen U₁, U₂ die in der Praxis nahezu gleich großen HF-Spannungen über den parasitären Kapazitäten C₁ bzw. C₂ - fließt folglich ein Großteil des Funkstörstroms i₂ über die Kapazität C₂ zur Kupferplatte 3 und nur ein geringerer Teil i₁' über die Kapazität C₁ zur Erde 2 ab, d.h. i₂ > i₁'. Idealerweise ist i₁' verschwindend gering, d.h. i₁' ≈ 0.

Figur 1c zeigt eine weitere erfindungsgemäße Anordnung in schematischer Darstellung. Im Unterschied zur Anordnung in Figur 1b ist hier die Kupferplatte 3 auf der der Erde 2 zugewandten Seite der Leiterbahn 1 angeordnet, d.h. zwischen Leiterbahn 1 und Erde 2. In der Praxis wird die Kupferplatte 3 gezielt mit einer Masseleiterbahn verbunden, deren HF-Potentialdifferenz zur Erde 2 im wesentlichen vernachlässigbar ist. Dadurch fließt der Funkstörstrom nahezu vollständig über die Kupferplatte 3 ab. Folglich ist der über die Erde 2 fließende Funkstörstrom i₄ vernachlässigbar gering, in jedem Fall aber wesentlich kleiner als der über die Kupferplatte 3 abfließende Funkstörstrom i₃.

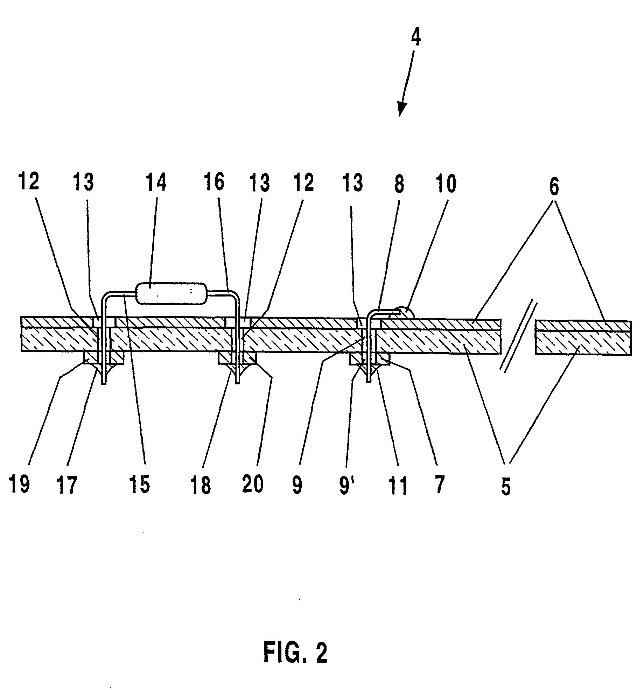

Figur 2 zeigt den Längsschnitt einer erfindungsgemäßen Anordnung 4 in schematischer Darstellung. Eine Leiterplatte 5 (dargestellt ist nur ein Teilbereich) ist auf ihrer Oberseite nahezu vollständig mit einer Kupferschicht 6 bedeckt. Die Kupferschicht 6 ist mit einer bezüglich schnellen Potentialänderungen ruhenden Masseleiterbahn 7 verbundenen. Sie fungiert so als Funkstörungen reduzierende Äquipotentialfläche. Zu diesem Zweck ist eine Drahtbrücke 8 in korrespondierenden Bohrungen 9,9' der Leiterplatte 5 bzw. der Masseleiterbahn 7 angeordnet. Mittels zweier Lötpunkte 10, 11 sind die beiden Enden der Drahtbrücke 8 mit der Kupferschicht 6 einerseits und der Masseleiterbahn 7 andererseits verbunden. Weitere Bohrungen 12 in der Leiterplatte 5 dienen in an sich bekannter Weise der Durchführung der Anschlüsse der elektronischen Bauelemente auf die Unterseite, d.h. auf die Lötseite der Leiterplatte 5. Im Bereich der Bohrungen 9, 12 ist die Kupferschicht 6 mit kreisförmigen Aussparungen 13 versehen, die unerwünschte Kontaktierungen zwischen den Anschlüssen und der Kupferschicht 6 verhindern. Die Verhältnisse sind exemplarisch anhand eines Zweipols 14 dargestellt. Der Zweipols 14 steht hier lediglich symbolisch für ein elektronisches Bauteil mit schnellen Potentialänderungen. Die beiden Anschlüsse 15, 16 des Zweipols 14 sind durch die Aussparungen 13 und Bohrungen 12 hindurch auf die Unterseite der Leiterplatte 5 geführt und dort mittels zweier Lötpunkte 17, 18 mit Leiterbahnen 19, 20 entsprechend der Schaltungsanordnung verbunden.

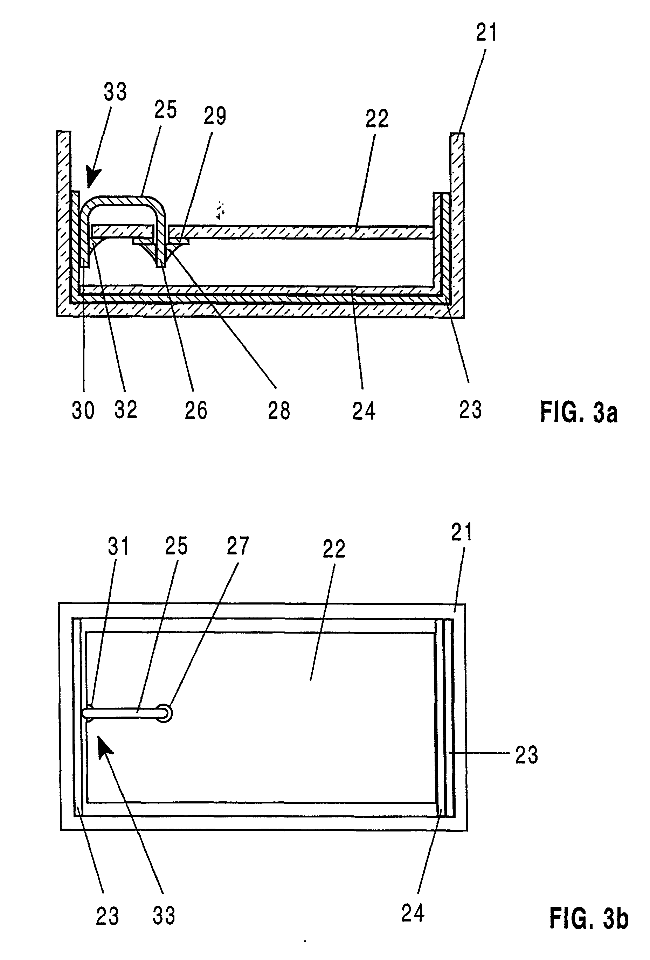

In den Figuren 3a und 3b ist eine Ausführung der Kontaktierung einer Abschirmfläche mit einer Masseleiterbahn auf einer Leiterplatte 22 innerhalb eines Schaltungsgehäuses 21 aus elektrisch nichtleitendem Material schematisch im Schnitt bzw. in der Draufsicht dargestellt. Die Abschirmfläche ist aus einer Metallfolie 23 und einer Isolierfolie 24 gebildet, wobei die Isolierfolie 24 zwischen der elektrisch leitenden Metallfolie 23 und der Leiterplatte 22 angeordnet ist. Ein erstes Ende 26 einer Drahtbrücke 25 ist durch eine Bohrung 27 in der Leiterplatte 22 hindurch geführt und mittels Lötpunkt 28 mit der Masseleiterbahn 29 der Schaltungsanordnung (nicht dargestellt) verbunden. Das zweite Ende 30 der Drahtbrücke 25 ist in einer halbkreisförmigen Kerbe 31 am Rand der Leiterplatte 22 geführt derart, daß dieser Teil der Drahtbrücke 25 über den Leiterplattenrand hinausragt. Mittels "halbem" Lötpunkt 32 ist das zweite Ende 30 der Drahtbrücke 25 auf der Unterseite der Leiterplatte 22 befestigt. Außerdem erstreckt sich die Isolierfolie 24 nur im Bereich der Unterseite der Leiterplatte 22. Die Metallfolie 23 hingegen erstreckt sich darüber hinaus auch noch zusätzlich entlang des Leiterplattenrandes mit der Kerbe 30. Auf diese Weise verhindert die Isolierfolie 24 elektrische Kurzschlüsse zwischen Bauteilen bzw. Anschlüssen (nicht dargestellt) auf der Leiterplatte und der Metallfolie 23. Andererseits sind die Metallfolie 23 und die Drahtbrücke 25 im Bereich 33 elektrisch kontaktiert. Dadurch ist folglich die abschirmende Wirkung der Metallfolie 23 sichergestellt. Die an sich auf der Leiterplatte 22 angeordneten Bauelemente der Schaltungsanordnung sind aus Gründen der Übersichtlichkeit hier nicht dargestellt. Außerdem sind der Klarheit der Darstellung wegen die Abmessungen der Drahtbrücke 25 sowie die Dicke von Metall 23- bzw. Isolierfolie 24 in Relation zu Leiterplatte 22 absichtlich vergrößert dargestellt.

In einer Variante (nicht dargestellt) bedeckt die Isolierfolie die der Leiterplatte zugewandte Seite der Metallfolie vollständig. Die beiden Folien sind am Leiterplattenrand auf der Seite der Drahtbrücke derart umgebördelt, daß dadurch dort die der Isolierfolie abgewandte Seite der Metallfolie in Richtung der Leiterplatte zeigt und folglich als Kontaktfläche für die Drahtbrükke dient. Bei geeigneter Wahl des Materials für die Metallfolie und deren Dicke, geeignet ist z.B. auch ein dünnes Kupferblech, kann gegebenenfalls die Federwirkung der Bördelung für eine erhöhte Druckkraft zwischen den Kontaktflächen des Metallbleches und der Drahtbrücke und folglich für eine verbesserte, zuverlässigere Kontaktierung dienen.

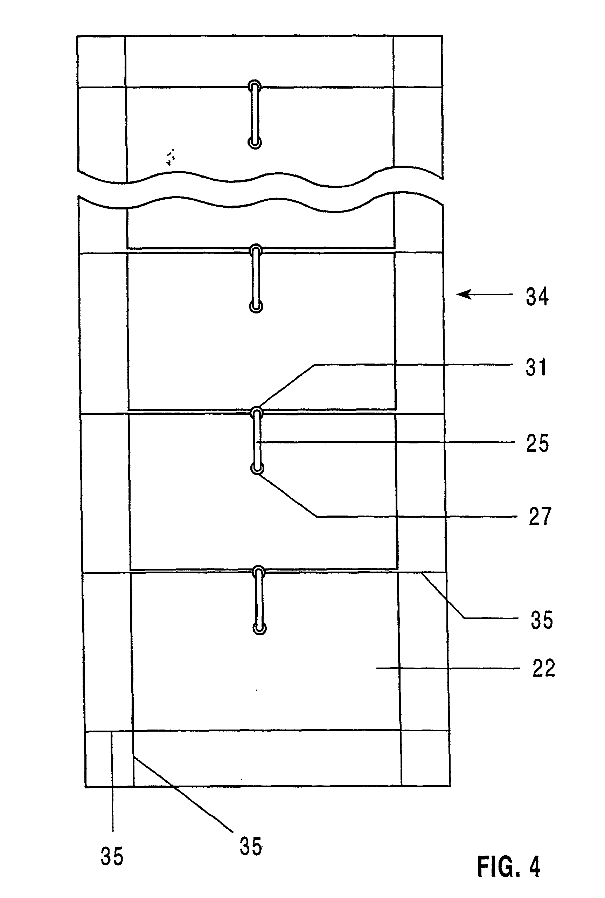

Figur 4 dient der Verdeutlichung des erfindungsgemäßen Verfahrens zur Herstellung der erfindungsgemäßen Leiterplatten mit Drahtbrücke zur Kontaktierung mit einer Äquipotentialfäche, z.B. einer Abschirmfolie oder gegebenenfalls dem metallischen Schaltungsgehäuse. Gleichartige Merkmale sind mit den entsprechenden Bezugsziffern der Figuren 3a, 3b bezeichnet. Gezeigt ist eine Nutzplatte 34 aus der eine Vielzahl einzelner Leiterplatten 22 der Art, wie in den Figuren 3a,3b gezeigt, hergestellt werden. Dazu wird die Nutzplatte 34- nachdem auf ihr die einzelnen Schaltungsanordnungen nebeneinander aufgebracht wurden (nicht dargestellt) - mit Ritzfräsungen 35 versehen, welche die einzelnen Schaltungsanordnungen umranden. Diese Ritzfräsungen 35 dienen später als Sollbruchstellen zum Ausbrechen der einzelnen Leiterplatten 22 aus der Nutzplatte 34. In diejenigen Ritzfräsungen, welche jeweils zwei unmittelbar benachbarte Leiterplatten voneinander trennen, wird je eine Bohrung 31 für die Drahtbrücken 25 angebracht. Außerdem ist im Leiterplatten-Layout bereits eine Bohrung 27 durch die Masseleiterbahn 29 (hier nicht dargestellt) hindurch vorgesehen. Danach wird je eine Drahtbrücke 25 pro Leiterplatte 22 mit ihrem ersten Ende 26 durch die zugehörige Bohrung 27 hindurch geführt und auf der Rückseite der Leiterplatte 22 mit einem Lötpunkt 28 verlötet (nicht dargestellt). Das jeweilige zweite Ende 30 der Drahtbrücken 25 wird durch die entsprechende Bohrung 31 hindurch geführt und auf der Rückseite der Leiterplatte 22 mit einem "halben" Lötpunkt 32 verlötet (hier nicht dargestellt; vgl. Fig. 3a). Nachdem die Leiterplatten 22 fertig bestückt und verlötet sind werden sie aus der Nutzplatte 34 entlang der Ritzfräsungen 35 herausgebrochen. Danach stehen die Drahtbrücken 25 jeweils im Bereich ihres zweiten Endes 30 etwas über den Rand der Leiterplatte 22 hinaus und sind gleichzeitig durch die teilkreisförmigen Aussparungen der ursprünglichen Bohrungen 31 fixiert.

Die Erfindung ist nicht auf die angegebenen Ausführungsbeispiele beschränkt. Insbesondere können einzelne Merkmale unterschiedlicher Ausführungsbeispiele auch miteinander kombiniert werden.

## Patentansprüche

1. Elektrische Schaltungsanordnung (4) mit einer Leiterplatte (5; 22) für den Betrieb von elektrischen Lampen, auf welcher Leiterplatte (5) elektrische Bauteile (14) und Leiterbahnen (7;19;20) angeordnet sind, wobei auf der Leiterplatte (5; 22) zeitlich schnelle Potentialänderungen auftreten, sowie mit einer Äquipotentialfläche (6; 23) zur Reduzierung der durch diese Potentialänderungen verursachten Funkstörungen, wobei die Äquipotentialfläche (6; 23) zumindest in der Nähe der Ober- oder Unterseite der Leiterplatte (5; 22) angeordnet ist, dadurch gekennzeichnet, daß die Äquipotentialfläche (6; 23) mittels galvanischer Kopplung (8, 10, 11; 25, 26, 28, 30, 32, 33) mit bezüglich der schnellen Potentialänderungen ruhendem Potential (7; 29) auf der Leiterplatte (5; 22) verbunden ist.

2. Schaltungsanordnung nach Anspruch 1, dadurch gekennzeichnet, daß die Äquipotentialfläche (6) die Oberseite der Leiterplatte (5) zumindest teilweise bedeckt, wobei diejenigen Bereiche (13) auf der Oberseite ausgespart sind, in welchen die Anschlüsse (15,16) der Bauteile (14) durch die Leiterplatte (5) hindurch zu den auf der Unterseite der Leiterplatte angeordneten Leiterbahnen (19;20) geführt sind.

3. Schaltungsanordnung nach Anspruch 2, dadurch gekennzeichnet, daß die Äquipotentialfläche (6) mittels einer Löt- oder Drahtbrücke (8) durch eine Bohrung (9) in der Leiterplatte (5) hindurch mit einer auf der Unterseite der Leiterplatte (5) angeordneten Masseleiterbahn (7) verbunden ist.

4. Schaltungsanordnung nach Anspruch 1, dadurch gekennzeichnet, daß die Äquipotentialfläche die Unterseite der Leiterplatte zumindest teilweise bedeckt, wobei diejenigen Bereiche der Unterseite ausgespart sind, in welchen Leiterbahnen verlaufen und/oder gegebenenfalls weitere elektrische (SMD[=Surface Mounted Device])Bauteile angeordnet sind.

5. Schaltungsanordnung nach Anspruch 4, dadurch gekennzeichnet, daß die Äquipotentialfläche mittels einer Löt- oder Drahtbrücke mit einer auf der Unterseite der Leiterplatte angeordnete Masseleiterbahn verbunden ist.

6. Schaltungsanordnung nach Anspruch 1, dadurch gekennzeichnet, daß die Äquipotentialfläche zwischen den Schichten einer mehrschichtigen Leiterplatte angeordnet ist.

7. Schaltungsanordnung nach einem der vorstehenden Ansprüche, dadurch gekennzeichnet, daß die Äquipotentialfläche aus einer Schicht (6) oder Platte (3) aus elektrisch gut leitendem Material besteht.

8. Schaltungsanordnung nach Anspruch 7, dadurch gekennzeichnet, daß die Platte in etwa die Fläche der Leiterplatte einnimmt.

9. Schaltungsanordnung nach Anspruch 7 oder 8, dadurch gekennzeichnet, daß die Platte im wesentlichen parallel zur Leiterplatte angeordnet ist.

10. Schaltungsanordnung nach Anspruch 7, dadurch gekennzeichnet, daß die Äquipotentialfläche aus zwei oder mehreren Teilflächen besteht.

11. Schaltungsanordnung nach Anspruch 7, dadurch gekennzeichnet, daß das Material aus Metall, insbesondere aus Kupfer, besteht.

12. Schaltungsanordnung nach Anspruch 7, dadurch gekennzeichnet, daß das Material aus einem elektrisch leitfähigen Kunststoff besteht.

13. Schaltungsanordnung nach Anspruch 1, dadurch gekennzeichnet, daß
- die Schaltungsanordnung eine Drahtbrücke (25) aufweist, deren erstes Ende (26) mit dem ruhenden Potential (29) verbunden ist und deren zweites Ende (30) über einen Rand der Leiterplatte (22) gebogen ist,
- die Leiterplatte (22) innerhalb eines Schaltungsgehäuses (21) angeordnet ist derart, daß der umgebogene Teil des zweiten Endes (30) der Drahtbrücke (25) die Äquipotentialfläche (6) zuverlässig elektrisch leitend kontaktiert.

14. Schaltungsanordnung nach Anspruch 13, dadurch gekennzeichnet, daß der Rand der Leiterplatte (22) eine Aussparung (31) aufweist, in welche Aussparung (31) der umgebogene Teil des zweiten Endes (30) der Drahtbrücke (25) teilweise eingebettet ist.

15. Schaltungsanordnung nach Anspruch 14, dadurch gekennzeichnet, daß die Aussparung (31) die Form eines Teilkreises aufweist.

16. Schaltungsanordnung nach Anspruch 13, dadurch gekennzeichnet, daß das umgebogene zweite Ende (30) der Drahtbrücke (25) mittels "halbem" Lötpunkt (32) im Bereich der Aussparung (31) auf der Leiterplatte (22) befestigt ist.

17. Schaltungsanordnung nach Anspruch 13, dadurch gekennzeichnet, daß das Schaltungsgehäuse (21) aus elektrisch nichtleitendem Material besteht und die Äquipotentialfläche (23) zwischen der Leiterplatte (22) und dem umgebogenen Teil des zweiten Endes (30) der Drahtbrükke (25) einerseits sowie der Innenwandung des Gehäuses (21) andererseits angeordnet ist, wobei die Innenwandung die Äquipotentialfläche (23) gegen das umgebogene zweite Ende (30) der Drahtbrücke (25) drückt und dadurch der elektrische Kontakt zwischen Äquipotentialfläche (23) und Drahtbrücke (25) sichergestellt ist.

18. Schaltungsanordnung nach Anspruch 17, dadurch gekennzeichnet, daß zwischen Äquipotentialfläche (23) und Leiterplatte (22) zusätzlich eine Isolierschicht (24) angeordnet ist.

19. Schaltungsanordnung nach Anspruch 18, dadurch gekennzeichnet, daß sich die Isolierschicht über die gesamte Äquipotentialfläche erstreckt und daß Isolierschicht und Äquipotentialfläche im Bereich des umgebogenen Teils des zweiten Endes der Drahtbrücke gebördelt sind derart, daß aufgrund der Bördelung die der Isolierschicht abgewandte Seite der Äquipotentialfläche den umgebogenen Teil des zweiten Endes der Drahtbrücke elektrisch leitend berührt.

20. Schaltungsanordnung nach Anspruch 17, dadurch gekennzeichnet, daß die Äquipotentialfläche aus einer Metallfolie (23) besteht.

21. Schaltungsanordnung nach Anspruch 1, dadurch gekennzeichnet, daß das Schaltungsgehäuse aus elektrisch leitendem Material besteht, welches Schaltungsgehäuse selbst die Äquipotentialfläche bildet.

22. Schaltungsanordnung nach Anspruch 1, dadurch gekennzeichnet, daß als bezüglich der schnellen Potentialänderungen ruhendes Potential eine Masseleiterbahn (29) der Schaltungsanordnung verwendet ist.

23. Verfahren zu Herstellung von Schaltungsanordnungen mit Merkmalen gemäß Anspruch 1 auf Leiterplatten, wobei zunächst eine Vielzahl von Schaltungsanordnungen auf einer Nutzplatte (34) nebeneinander angeordnet werden und wobei jede Schaltungsanordnung auf der Nutzplatte (34) durch Ritzfräsungen (35), welche am Ende der Herstellung die Ränder der einzelnen Leiterplatten definieren, begrenzt wird, gekennzeichnet durch folgende Verfahrensschritte,
- Bohren von jeweils einer ersten Bohrung (27) in die Leiterbahnen (29) der Schaltungsanordnungen, welche Leiterbahnen (29) bezüglich der schnellen Potentialänderungen auf ruhendem Potential liegen,
- Bohren von jeweils einer zweiten Bohrung (31) in die Ritzfräsungen (35), welche die Schaltungsanordnungen gegeneinander abgrenzen,
- Bereitstellen jeweils einer Drahtbrücke (25) pro Schaltungsanordnung, welche Drahtbrücke (25) zwei Enden (26,30) aufweist,
- Einsetzen des ersten (26) sowie des zweiten Endes (30) jeder Drahtbrücke (25) in die erste (27) bzw. zweite Bohrung (31) jeder Schaltungsanordnung,
- Verlöten des ersten Endes (26) jeder Drahtbrücke (25) mit je einem Lötpunkt (28) und des zweiten Endes (30) jeder Drahtbrücke (25) mit je einem "halben" Lötpunkt (32) auf der Nutzplatte (34), wobei die "halben" Lötpunkte (32) die entsprechenden Ritzfräsungen aussparen,
- Abtrennen der einzelnen Leiterplatten (22) aus der Nutzplatte (34) entlang der Ritzfräsungen, wonach jede Leiterplatte (22) an einem ihrer Ränder eine teilkreisförmige Aussparung (31) als verbliebenem Rest der zugehörigen zweiten Bohrung (31) aufweist, in welche Aussparung (31) jeweils der umgebogene Teil des zweiten Endes (30) der zugehörigen Drahtbrücke (25) teilweise eingebettet ist.

## Claims

1. Electrical circuit arrangement (4) with a printed circuit board (5;22) for the operation of electrical lamps, on which printed circuit board (5) electrical components (14) and conductor tracks (7;19;20) are arranged, potential changes that are rapid with respect to time occurring on the printed circuit board (5;22), and also with an equipotential surface (6;23) for reducing the radio interference caused by these potential changes, the equipotential surface (6;23) being arranged at least in the vicinity of the top side or underside of the printed circuit board (5;22), characterized in that the equipotential surface (6;23) is connected by means of direct electrical coupling (8,10,11;25,26,28,30,32,33) to quiescent potential (7;29) relative to the rapid potential changes on the printed circuit board (5;22).

2. Circuit arrangement according to Claim 1, characterized in that the equipotential surface (6) at least partially covers the top side of the printed circuit board (5), those regions (13) on the top side being spared in which the terminals (15,16) of the components (14) are guided through the printed circuit board (5) to the conductor tracks (19;20) arranged on the underside of the printed circuit board.

3. Circuit arrangement according to Claim 2, characterized in that the equipotential surface (6) is connected to an earth conductor track (7), arranged on the underside of the printed circuit board (5), by means of a soldering or wire bridge (8) through a hole (9) in the printed circuit board (5).

4. Circuit arrangement according to Claim 1, characterized in that the equipotential surface at least partially covers the underside of the printed circuit board, those regions of the underside being spared in which conductor tracks run and/or, if appropriate, further electrical (SMD[=Surface Mounted Device]) components are arranged.

5. Circuit arrangement according to Claim 4, characterized in that the equipotential surface is connected to an earth conductor track, arranged on the underside of the printed circuit board, by means of a soldering or wire bridge.

6. Circuit arrangement according to Claim 1, characterized in that the equipotential surface is arranged between the layers of a multilayer printed circuit board.

7. Circuit arrangement according to one of the preceding claims, characterized in that the equipotential surface comprises a layer (6) or plate (3) made of readily electrically conductive material.

8. Circuit arrangement according to Claim 7, characterized in that the plate occupies roughly the surface of the printed circuit board.

9. Circuit arrangement according to Claims 7 or 8, characterized in that the plate is essentially arranged parallel to the printed circuit board.

10. Circuit arrangement according to Claim 7, characterized in that the equipotential surface comprises two or more partial surfaces.

11. Circuit arrangement according to Claim 7, characterized in that the material is composed of metal, in particular copper.

12. Circuit arrangement according to Claim 7, characterized in that the material is composed of an electrically conductive plastic.

13. Circuit arrangement according to Claim 1, characterized in that
- the circuit arrangement has a wire bridge (25), whose first end (26) is connected to the quiescent potential (29) and whose second end (30) is bent over an edge of the printed circuit board (22),
- the printed circuit board (22) is arranged inside a circuit housing (21) in such a way that the bent-over part of the second end (30) of the wire bridge (25) makes reliable electrically conductive contact with the equipotential surface (6).

14. Circuit arrangement according to Claim 13, characterized in that the edge of the printed circuit board (22) has a cutout (31), in which cutout (31) the bent-over part of the second end (30) of the wire bridge (25) is partially embedded.

15. Circuit arrangement according to Claim 14, characterized in that the cutout (31) has the form of a partial circle.

16. Circuit arrangement according to Claim 13, characterized in that the bent-over second end (30) of the wire bridge (25) is fixed by means of "half" soldering point (32), in the region of the cutout (31) on the printed circuit board (22).

17. Circuit arrangement according to Claim 13, characterized in that the circuit housing (21) is composed of electrically non-conductive material and the equipotential surface (23) is arranged between the printed circuit board (22) and the bent-over part of the second end (30) of the wire bridge (25), on the one hand, and the inner wall of the housing (21), on the other hand, the inner wall pressing the equipotential surface (23) against the bent-over second end (30) of the wire bridge (25) and the electrical contact between equipotential surface (23) and wire bridge (25) thereby being ensured.

18. Circuit arrangement according to Claim 17, characterized in that an insulating layer (24) is additionally arranged between equipotential surface (23) and printed circuit board (22).

19. Circuit arrangement according to Claim 18, characterized in that the insulating layer extends over the entire equipotential surface, and in that insulating layer and equipotential surface are flanged in the region of the bent-over part of the second end of the wire bridge, in such a way that, on account of the flanging, that side of the equipotential surface which is remote from the insulating layer touches the bent-over part of the second end of the wire bridge in an electrically conductive manner.

20. Circuit arrangement according to Claim 17, characterized in that the equipotential surface comprises a metal foil (23).

21. Circuit arrangement according to Claim 1, characterized in that the circuit housing is composed of electrically conductive material, which circuit housing itself forms the equipotential surface.

22. Circuit arrangement according to Claim 1, characterized in that an earth conductor track (29) of the circuit arrangement is used as the quiescent potential relative to the rapid potential changes.

23. Method for producing circuit arrangements having features according to Claim 1 on printed circuit boards, firstly a multiplicity of circuit arrangements being arranged next to one another on a useful board (34) and each circuit arrangement on the useful board (34) being bounded by gap millings (35), which define the edges of the individual printed circuit boards at the end of production, characterized by the following method steps:
- boring of a respective first hole (27) into the conductor tracks (29) of the circuit arrangements, which conductor tracks (29) are at quiescent potential relative to the rapid potential changes,
- boring of a respective second hole (31) into the gap millings (35), which delimit the circuit arrangements with respect to one another,
- provision of a respective wire bridge (25) for each circuit arrangement, which wire bridge (25) has two ends (26,30),
- insertion of the first end (26) and of the second end (30) of each wire bridge (25) into the first hole (27) and the second hole (31), respectively, of each circuit arrangement,
- soldering of the first end (26) of each wire bridge (25) with a respective soldering point (28) and of the second end (30) of each wire bridge (25) with a respective "half" soldering point (32) on the useful board (34), the "half" soldering points (32) leaving open the corresponding gap millings,
- separation of the individual printed circuit boards (22) from the useful board (34) along the gap millings, after which each printed circuit board (22) has, on one of its edges, a partial-circle-shaped cutout (31) as the remainder of the associated second hole (31), in which cutout (31) in each case the bent-over part of the second end (30) of the associated wire bridge (25) is partially embedded.

## Revendications

1. Montage (4) électrique comportant une plaquette (5 ; 22) à circuits imprimés pour faire fonctionner des lampes électriques, des composants (14) électriques et des pistes (7 ; 19 ; 20) conductrices étant disposés sur la plaquette (5) à circuits imprimés, des variations de potentiel rapides dans le temps apparaissant sur la plaquette (5 ; 22) à circuits imprimés, et comportant une surface (6 ; 23) d'équipotentiel pour la réduction des parasitages provoqués par ces variations de potentiel, la surface (6 ; 23) d'équipotentiel étant disposée au moins à proximité de la face supérieure ou de la face inférieure de la plaquette (5 ; 22) à circuits imprimés, caractérisé en ce que la surface (6 ; 23) d'équipotentiel est reliée au moyen de couplage (8, 10, 11 ; 25, 26, 28, 30, 32, 33) galvanique au potentiel (7 ; 29) statique par rapport aux variations rapides de potentiel sur la plaquette (5 ; 22) à circuits imprimés.

2. Montage suivant la revendication 1, caractérisé en ce que la surface (6) d'équipotentiel recouvre au moins en partie la face supérieure de la plaquette (5) à circuits imprimés, les régions (13) sur la face supérieure dans lesquelles les bornes (15, 16) des composants (14) sont guidées, en passant par la plaquette (5) à circuits imprimés, aux pistes (19 ; 20) conductrices disposées sur la face inférieure de la plaquette à circuits imprimés étant épargnées.

3. Montage suivant la revendication 2, caractérisé en ce que la surface (6) d'équipotentiel est reliée au moyen d'un pont (8) de brasure ou d'un fil de liaison, en passant par un trou (9) dans la plaquette (5) à circuits imprimés, à une piste (7) conductrice de masse disposée sur la face inférieure de la plaquette (5) à circuits imprimés.

4. Montage suivant la revendication 1, caractérisé en ce que la surface d'équipotentiel recouvre au moins partiellement la face inférieure de la plaquette à circuits imprimés, les régions de la face inférieure dans lesquelles des pistes conductrices s'étendent et/ou dans lesquelles sont disposés le cas échéant des composants (SMD[=Surface Mounted Device]) électriques supplémentaires étant épargnées.

5. Montage suivant la revendication 4, caractérisé en ce que la surface d'équipotentiel est reliée au moyen d'un pont de brasure ou d'un fil de liaison à une piste conductrice de masse disposée sur la face inférieure de la plaquette à circuits imprimés.

6. Montage suivant la revendication 1, caractérisé en ce que la surface d'équipotentiel est disposée entre les couches d'une plaquette à circuits imprimés multicouche.

7. Montage suivant l'une des revendications précédentes, caractérisé en ce que la surface d'équipotentiel est constituée d'une couche (6) ou d'une plaquette (3) en matériau bon conducteur de l'électricité.

8. Montage suivant la revendication 7, caractérisé en ce que la plaquette prend à peu près la surface de la plaquette à circuits imprimés.

9. Montage suivant la revendication 7 ou 8, caractérisé en ce que la plaquette est disposée sensiblement parallèlement à la plaquette à circuits imprimés.

10. Montage suivant la revendication 7, caractérisé en ce que la surface d'équipotentiel est constituée de deux ou plusieurs surfaces partielles.

11. Montage suivant la revendication 7, caractérisé en ce que le matériau est en métal, notamment en cuivre.

12. Montage suivant la revendication 7, caractérisé en ce que le matériau est en une matière plastique conductrice de l'électricité.

13. Montage suivant la revendication 1, caractérisé en ce que
- le montage comporte un fil (25) de liaison dont la première extrémité (26) est reliée au potentiel (29) statique et dont la deuxième extrémité (30) est recourbée sur un bord de la plaquette (22) à circuits imprimés,
- la plaquette (22) à circuits imprimés est disposée à l'intérieur d'un boîtier (21) de circuits de telle manière que la partie recourbée de la deuxième extrémité (30) du fil (25) de liaison contacte de façon fiable de manière conductrice de l'électricité la surface (6) d'équipotentiel.

14. Montage suivant la revendication 13, caractérisé en ce que le bord de la plaquette (22) à circuits imprimés comporte un évidement (31) dans lequel la partie recourbée de la deuxième extrémité (30) du fil (25) de liaison est en partie enrobée.

15. Montage suivant la revendication 14, caractérisé en ce que l'évidement (31) a la forme d'une partie de cercle.

16. Montage suivant la revendication 13, caractérisé en ce que la deuxième extrémité (30) recourbée du fil (25) de liaison est fixée à la plaquette (22) à circuits imprimés au moyen d'un "demi" point (32) de brasage dans la région de l'évidement (31).

17. Montage suivant la revendication 13, caractérisé en ce que le boîtier (21) de circuits est en un matériau non conducteur de l'électricité et en ce que la surface (23) d'équipotentiel est disposée entre la plaquette (22) à circuits imprimés et la partie recourbée de la deuxième extrémité (30) du fil (25) de liaison, d'une part, et la paroi intérieure du boîtier (21), d'autre part, la paroi intérieure pressant la surface (23) d'équipotentiel sur la deuxième extrémité (30) recourbée du fil (25) de liaison et le contact électrique entre la surface (23) d'équipotentiel et le fil (25) de liaison étant ainsi assuré.

18. Montage suivant la revendication 17, caractérisé en ce qu'une couche (24) isolante est disposée de plus entre la surface (23) d'équipotentiel et la plaquette (22) à circuits imprimés.

19. Montage suivant la revendication 18, caractérisé en ce que la couche isolante s'étend sur toute la surface d'équipotentiel et en ce que la couche isolante et la surface d'équipotentiel sont repliées dans la région de la partie recourbée de la deuxième extrémité du fil de liaison de telle manière que, en raison du repli, la partie de la surface d'équipotentiel éloignée de la couche isolante touche de manière conductrice de l'électricité la partie recourbée de la deuxième extrémité du fil de liaison.

20. Montage suivant la revendication 17, caractérisé en ce que la surface d'équipotentiel est constituée d'un ruban (23) métallique.

21. Montage suivant la revendication 1, caractérisé en ce que le boîtier de circuits est en un matériau conducteur de l'électricité, le boîtier de circuits formant lui-même la surface d'équipotentiel.

22. Montage suivant la revendication 1, caractérisé en ce qu'il est utilisé comme potentiel statique par rapport aux rapides variations de potentiel une piste (29) conductrice de masse du montage.

23. Procédé de fabrication de montage comportant des caractéristiques suivant la revendication 1 sur des plaquettes à circuits imprimés, une pluralité de montages étant d'abord disposés côte à côte sur une plaquette (34) utile et chaque montage étant délimité sur la plaquette (34) utile par des fraisures (35) par entaille qui définissent à la fin de la fabrication les bords des plaquettes à circuits imprimés individuelles, caractérisé par les étapes opératoires suivantes,
- on perce chaque fois un premier trou (27) dans les pistes (29) conductrices des montages, ces pistes (29) conductrices étant à un potentiel statique par rapport aux rapides variations de potentiel,
- on perce chaque fois un deuxième trou (31) dans les fraisures (35) par entaille qui délimitent les montages les uns par rapport aux autres,
- on prépare chaque fois un fil (25) de liaison par montage, ce fil (25) de liaison comportant deux extrémités (26, 30),
- on introduit la première extrémité (26) ainsi que la deuxième extrémité (30) de chaque fil (25) de liaison respectivement dans le premier trou (27) et le deuxième trou (31) de chaque montage,
- on brase la première extrémité (26) de chaque fil (25) de liaison chaque fois par un point (28) de brasage et on brase la deuxième extrémité (30) de chaque fil (25) de liaison chaque fois par un "demi" point (32) de brasage sur la plaquette (34) utile, les "demi" points (32) de brasage épargnant les fraisures par entaille correspondantes,
- On sépare les plaquettes (22) à circuits imprimés individuelles de la plaquette (33) utile le long des fraisures par entaille, après quoi chaque plaquette (22) à circuits imprimés comporte sur l'un de ses bords un évidement (31) en forme de partie de cercle comme reste qui demeure du deuxième trou (31) associé, chaque fois la partie recourbée de la deuxième extrémité (30) du fil (25) de liaison associé étant en partie enrobée dans cet évidement (31).
